(19) Europäisches Patentamt
European Patent Office
Office européen des brevets

(11) **EP 2 845 286 B1**

(12) **EUROPÄISCHE PATENTSCHRIFT**

(45) Veröffentlichungstag und Bekanntmachung des Hinweises auf die Patenterteilung:
**03.04.2019 Patentblatt 2019/14**

(21) Anmeldenummer: **12734852.2**

(22) Anmeldetag: **26.06.2012**

(51) Int Cl.:
*H02J 3/00* (2006.01)     *H02H 6/00* (2006.01)
*H02H 3/00* (2006.01)     *H02S 50/10* (2014.01)
*H02H 7/26* (2006.01)     *H02J 13/00* (2006.01)

(86) Internationale Anmeldenummer:
**PCT/EP2012/062314**

(87) Internationale Veröffentlichungsnummer:
**WO 2014/000769 (03.01.2014 Gazette 2014/01)**

(54) **FEHLERERKENNUNG IN ENERGIEVERSORGUNGSNETZEN**

FAULT DETECTION IN ENERGY SUPPLY NETWORKS

DÉTECTION DE DÉFAUTS DANS DES RÉSEAUX D'ALIMENTATION EN ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**11.03.2015 Patentblatt 2015/11**

(73) Patentinhaber: **Siemens Aktiengesellschaft**
**80333 München (DE)**

(72) Erfinder:
• **JANSSEN, Pierre**
  **B-1180 Bruessel (BE)**
• **MAUN, Jean-Claude**
  **B-1140 Bruessel (BE)**

(56) Entgegenhaltungen:
**US-B1- 6 518 768**

• **Michael Hurtgen ET AL: "Advantages of power system state estimation using Phasor Measurement Units", 16th PSCC, 18. Juli 2008 (2008-07-18), XP55040448, ISBN: 978-0-94-764928-9 Gefunden im Internet: URL:http://www.pscc-central.org/uploads/tx _ethpublications/pscc2008_520.pdf [gefunden am 2012-10-09] in der Anmeldung erwähnt**
• **LU C N ET AL: "DISTRIBUTION SYSTEM STATE ESTIMATION", IEEE TRANSACTIONS ON POWER SYSTEMS, IEEE SERVICE CENTER, PISCATAWAY, NJ, US, Bd. 10, Nr. 1, 1. Februar 1995 (1995-02-01), Seiten 229-240, XP000513239, ISSN: 0885-8950, DOI: 10.1109/59.373946 in der Anmeldung erwähnt**
• **MICHAEL HURTGEN ET AL: "Measurement placement algorithms for state estimation when the number of phasor measurements by each PMU is limited", UNIVERSITIES POWER ENGINEERING CONFERENCE, 2008. UPEC 2008. 43RD INTERNATIONAL, IEEE, PISCATAWAY, NJ, USA, 1. September 2008 (2008-09-01), Seiten 1-5, XP031348950, ISBN: 978-1-4244-3294-3**

**EP 2 845 286 B1**

**Beschreibung**

Die im Folgenden beschriebene Erfindung ist im Rahmen einer Zusammenarbeit zwischen der Siemens AG und der Fakultät für Angewandte Wissenschaften Bio-, Elektro- und Mechanische Systeme (Faculty of Applied Sciences Bio-, Electro- And Mechanical Systems) der Freien Universität Brüssel ULB (Universite Libre de Bruxelles) unter der Leitung von Professor Dr. Maun entwickelt worden.

Die Erfindung betrifft ein Verfahren zum Erkennen eines Fehlers in einem elektrischen Energieversorgungsnetz, bei dem für mehrere Messstellen in dem Energieversorgungsnetz Zustandswerte bestimmt werden, die einen an der jeweiligen Messstelle vorliegenden elektrischen Zustand des Energieversorgungsnetzes angeben, die Zustandswerte zu einer zentralen Leitstelleneinrichtung übermittelt werden, die eine Auswerteeinrichtung umfasst, übermittelt werden und die Zustandswerte von der Auswerteeinrichtung zur Erkennung eines in dem Energieversorgungsnetz vorliegenden Fehlers herangezogen werden. Die Erfindung betrifft auch eine Leitstelleneinrichtung zum Erkennen eines Fehlers in einem elektrischen Energieversorgungsnetz mit einer Auswerteeinrichtung zur Erfassung von für mehrere Messstellen in dem Energieversorgungsnetz ermittelten Zustandswerten, die einen an der jeweiligen Messstelle vorliegenden elektrischen Zustand des Energieversorgungsnetzes angeben und die zur Erkennung eines in dem Energieversorgungsnetz vorliegenden Fehlers anhand der Zustandswerte eingerichtet ist.

Elektrische Energieversorgungsnetze werden üblicherweise abschnittsweise mit sogenannten Schutzgeräten auf Fehler, wie beispielsweise Kurzschlüsse oder Erdschlüsse, überwacht. Beim Auftreten eines solchen unzulässigen Betriebszustands trennen die Schutzgeräte den von dem Fehler betroffenen Teil des Energieversorgungsnetzes vom restlichen Netz durch Öffnen entsprechender Leistungsschalter ab und vermeiden so eine Gefährdung für Personen und Komponenten des elektrischen Energieversorgungsnetzes. Zur Überwachung der einzelnen Abschnitte des elektrischen Energieversorgungsnetzes führen die Schutzgeräte sogenannte Schutzalgorithmen aus. Hierbei wird unter Verwendung von Messwerten, bei denen es sich beispielsweise um den Strom und die Spannung an einer Messstelle des elektrischen Energieversorgungsnetzes charakterisierende Messwerte handeln kann, eine Entscheidung darüber getroffen, ob ein unzulässiger oder ein zulässiger Betriebszustand vorliegt.

Beispielsweise beschreibt die US 6,518,768 B1 ein System aus mehreren Differentialschutzgeräten zur Überwachung eines Leitungsabschnitts mit mehreren Enden hinsichtlich des Auftretens von Fehlern.

Mittlerweile gibt es darüber hinaus Bestrebungen, eine Schutzauswertung für ein Energieversorgungsnetz zentral zusammenzuführen. Beispielsweise ist aus der US 6,985,784 B2 bekannt, an mehreren Messstellen in einem Energieversorgungsnetz aufgenommene Messwerte an ein zentrales Steuerungssystem zu übertragen. Das beschriebene zentrale Steuerungssystem stellt eine Rechneranordnung dar, mittels der die üblicherweise in den einzelnen dezentralen Schutzgeräten ausgeführten Schutzalgorithmen unter Verwendung der übertragenen Messwerte zentral ausgeführt werden. Bei Erkennung eines Fehlers wird ein entsprechendes Auslösesignal an einen Schalter übertragen, der den betroffenen Netzabschnitt vom übrigen Energieversorgungsnetz abtrennt.

Da mit dem zentralen Steuerungssystem quasi eine Vielzahl von Schutzgeräten auf einer Rechneranordnung betrieben wird, entsteht ein vergleichsweise hoher Aufwand bei der Projektierung, Inbetriebsetzung und Parametrierung des zentralen Steuerungssystems.

In heutigen Energieversorgungsnetzen mit einer großen Anzahl dezentraler Einspeisungen elektrischer Energie, beispielsweise durch Photovoltaik- oder Windkraftanlagen besteht darüber hinaus das Problem, dass aufgrund der durch Umrichter gesteuerten Einspeisung nur relativ geringe Kurzschlussströme verfügbar sind, d.h. auch bei Vorliegen eines Fehlers in dem Energieversorgungsnetz steigt der Kurzschlussstrom vergleichsweise schwach an, so dass eine Detektion mit den bekannten Schutzalgorithmen erschwert ist. Dieses Problem besteht insbesondere in sogenannten "Microgrids", also kleinen, in sich abgeschlossenen Energieversorgungsnetzen, und Inselnetzen, ist aber auch in größeren, komplexen Energieversorgungsnetzen mit steigendem Anteil an Einspeisung elektrischer Energie aus regenerativen Quellen zu beobachten.

Der vorliegenden Erfindung liegt die Aufgabe zugrunde, ein Verfahren bzw. eine Leitstelleneinrichtung der eingangs genannten Art derart fortzubilden, dass auftretende Fehler, insbesondere auch in Energieversorgungsnetzen mit geringen Kurzschlussströmen, mit hoher Zuverlässigkeit und Selektivität erkannt werden können.

Zur Lösung dieser Aufgabe hinsichtlich des Verfahrens wird ein Verfahren der eingangs genannten Art vorgeschlagen, bei dem mittels der Auswerteeinrichtung eine Zustandsschätzung ausgeführt wird, die sich einer Modellbeschreibung des elektrischen Energieversorgungsnetzes bedient, die zur Beschreibung möglicher elektrischer Zustände des Energieversorgungsnetzes anhand von Zustandsvariablen geeignet ist, während der Zustandsschätzung überprüft wird, ob sich durch die Modellbeschreibung ein elektrischer Zustand des Energieversorgungsnetzes beschreiben lässt, der hinsichtlich der für die jeweiligen Messstellen verwendeten Zustandsvariablen zumindest näherungsweise mit den jeweiligen Zustandswerten übereinstimmt, indem mittels der Auswerteeinrichtung eine Minimierung einer Kostenfunktion von durch die Modellbeschreibung beschriebenen Zuständen des Energieversorgungsnetzes durchgeführt wird, um denjenigen Satz von Zustandsvariablen aus allen möglichen Zustandsvariablen zu ermitteln, mittels dessen mit der Modellbeschreibung die tatsächlich in dem Energieversorgungsnetz vorliegenden Zustandswerte abgebildet werden können; auf ein Fehlen eines beschreibbaren Zustands geschlossen wird, wenn das Ergebnis der Kostenfunktion oberhalb eines einstellbaren Schwellenwertes liegt, und bei Fehlen eines solchen Zustands von der Auswerteeinrichtung ein Fehlererkennungssignal erzeugt wird, das ein Vorliegen eines Fehlers in dem Energieversorgungsnetz angibt.

Das erfindungsgemäße Verfahren macht sich hierbei in neuartiger Weise die Funktionsweise eines Zustandsschätzers, in der entsprechenden Fachterminologie auch als "State-Estimator" bezeichnet, zunutze.

Bei einer Zustandsschätzung wird prinzipiell ein elektrischer Zustand eines Energieversorgungsnetzes anhand möglichst redundant vorliegender Zustandswerte für mehrere Messstellen des Energieversorgungsnetzes ermittelt. Die Schwierigkeit dabei ist, dass normalerweise nicht für alle möglichen Stellen in dem Energieversorgungsnetz Zustandswerte bekannt sind, beispielsweise weil aus Kostengründen nur eine begrenzte Anzahl von Messsensoren installiert wird. Beim herkömmlichen Betrieb eines Zustandsschätzers wird daher mittels des Zustandsschätzers ein möglichst genaues mathematisches Modell des betrachteten Energieversorgungsnetzes implementiert, mit dem anhand der für die vorhandenen Messstellen vorliegenden Zustandswerte, die z.B. in Form von Strömen, Spannungen oder Leistungen vorliegen können, der Netzzustand an allen mögliche Punkten des Energieversorgungsnetzes bestimmt werden kann. Ein solcher Zustand setzt sich mathematisch aus einem Vektor von Zustandsvariablen zusammen, die beispielsweise die Spannung an allen betrachteten Punkten des Energieversorgungsnetzes angeben. Weitere Zustandsvariablen können beispielsweise eine Veränderung eines Phasenunterschieds bei unsynchronisierten Messgeräten, die Abzweigströme und die Einstellung von Transformatorstufenstellern sein. Herkömmliche Zustandsschätzer dienen somit zur Überwachung und Visualisierung der Betriebszustände von Energieversorgungsnetzen und werden üblicherweise in Netzleitstellen eingesetzt. Außerdem können mit einem Zustandsschätzer Sensorfehler der die Zustandswerte aufnehmenden Messgeräte erkannt werden.

Zustandsschätzer zur Überwachung von Energieübertragungsnetzen sind beispielsweise aus der Veröffentlichung von A. Abur und A. Gomez Exposito "Power System State Estimation", New York: Marcel Dekker, 2004, bekannt. Die Möglichkeit, Zustandsschätzer auch für dreiphasige Verteilnetze einzusetzen, ist zudem beispielsweise in der Veröffentlichung von C. Lu, J. Teng und W.-H. E. Liu "Distribution system state estimation", IEEE Transactions on Power Systems, pp. 229-240, 1995, beschrieben. Außerdem ist im Aufsatz von Michael Hurtgen "Advantages of power system state estimation using Phasor Measurement Units", Proceedings of the Power Systems Computation Conference, 2008, die Verwendung von sogenannten Phasormessgeräten ("Phasor Measurement Units") als Messgeräte zur Erfassung von Zustandswerten für einen Zustandsschätzer beschrieben.

Die Erfindung setzt nun einen Zustandsschätzer in neuer Weise zur Erkennung eines Fehlers in einem Energieversorgungsnetz ein, indem überprüft wird, ob mittels der Modellbeschreibung ein Zustand des Energieversorgungsnetzes abgebildet werden kann, der mit den erfassten Zustandswerten in weitgehende Übereinstimmung gebracht werden kann. Ist dies der Fall, so wird das Energieversorgungsnetz als fehlerfrei angesehen und es wird entsprechend kein Fehlererkennungssignal erzeugt. Können die Zustandswerte hingegen nicht mit einem von der Modellbeschreibung beschreibbaren Zustand des Energieversorgungsnetzes in Übereinstimmung gebracht werden, so kann darauf geschlossen werden, dass im Energieversorgungsnetz ein Fehler vorliegt und es wird folglich das Fehlererkennungssignal erzeugt.

Erfindungsgemäß ist vorgesehen, dass zur Überprüfung, ob sich durch die Modellbeschreibung ein elektrischer Zustand des Energieversorgungsnetzes beschreiben lässt, der hinsichtlich der für die jeweiligen Messstellen verwendeten Zustandsvariablen zumindest näherungsweise mit den jeweiligen Zustandswerten übereinstimmt, mittels der Auswerteeinrichtung eine Minimierung einer Kostenfunktion von durch die Modellbeschreibung beschreibbaren Zuständen des Energieversorgungsnetzes durchgeführt wird, und auf ein Fehlen eines beschreibbaren Zustands geschlossen wird, wenn das Ergebnis der Kostenfunktion oberhalb eines einstellbaren Schwellenwertes liegt.

Durch die Minimierung der Kostenfunktion kann derjenige Satz von Zustandsvariablen aus allen möglichen Zustandsvariablen ermittelt werden, mittels dessen mit der Modellbeschreibung die tatsächlich vorliegenden Zustandswerte abgebildet werden können.

Das erfindungsgemäße Fehlererkennungsverfahren kann vorteilhaft als Primärschutz, insbesondere aber als systemweiter zentraler Backupschutz neben bestehenden dezentralen Schutzgeräten eingesetzt werden. Außerdem kann mit gespeicherten Zustandswerten auch eine Offline-Fehleranalyse durchgeführt werden.

Eine vorteilhafte Ausführungsform des erfindungsgemäßen Verfahrens sieht vor, dass die Zustandsschätzung mittels der Auswerteeinrichtung für eine abgegrenzte Schutzzone des Energieversorgungsnetzes ausgeführt wird, während der Zustandsschätzung überprüft wird, ob sich durch die Modellbeschreibung ein elektrischer Zustand der Schutzzone beschreiben lässt, der hinsichtlich der für die in der Schutzzone liegenden jeweiligen Messstellen verwendeten Zustandsvariablen zumindest näherungsweise mit den jeweiligen Zustandswerten übereinstimmt, und bei Fehlen eines solchen Zustands von der Auswerteeinrichtung das Fehlererkennnungssignal in Form eines Fehlerzonensignals erzeugt wird, das ein Vorliegen eines Fehlers in der Schutzzone angibt.

Bei dieser Ausführungsform wird quasi eine lokale Zustandsschätzung für eine (oder mehrere) einzelne Schutzzone(n) des Energieversorgungsnetzes durchgeführt. Anhand des Ergebnisses der Zustandsschätzung kann direkt darauf geschlossen werden, ob die überwachte Schutzzone fehlerbehaftet ist.

In diesem Zusammenhang kann vorgesehen sein, dass bei Vorliegen des Fehlerzonensignals für die von dem Fehler betroffene Schutzzone an einem oder mehreren Enden der Schutzzone vorliegende Werte für Ströme und Spannungen bestimmt werden und mittels der so, beispielsweise aus den für die gesunden Teilen des Energieversorgungsnetzes bestimmten Zustandsschätzungen, bestimmten Werte für Ströme und Spannungen eine Berechnung desjenigen Ortes innerhalb der Schutzzone durchgeführt wird, an dem der Fehler aufgetreten ist.

Auf diese Weise kann innerhalb der überwachten Schutzzone eine genaue Fehlerortung durchgeführt werden. Anhand der Modellbeschreibung des Energieversorgungsnetzes und den Zustandsvariablen für fehlerfreie Teilabschnitte des Energieversorgungsnetzes außerhalb der fraglichen Schutzzone kann für die Grenzen bzw. Enden der Schutzzone eine Angabe über dort vorliegende Ströme und Spannungen gemacht werden. Aus diesen Werten lässt sich anhand an sich bekannter Fehlerortungsalgorithmen der genaue Fehlerort ableiten; dabei können für die Fehlerortung Ströme und Spannungen von einem Ende oder mehreren Enden der Schutzzone verwendet werden. Beispiele für Fehlerortungsverfahren finden sich beispielsweise in der US 5,929,642 oder in dem Aufsatz von M.M. Saha, J. Izykowski und E. Rosolowski "Fault Location on Power Networks", 2010, London, Springer-Verlag.

Mittels einer solchen genauen Fehlerortung kann vorteilhaft ein Reparatur- und Wartungsmanagement unterstützt werden; außerdem kann die Fehlerortung auch zu weiteren Schutzzwecken - ähnlich wie bei einem Distanzschutzgerät - herangezogen werden.

Prinzipiell wird bis zur Fehlerortung also ein zweistufiges Verfahren durchlaufen: Zunächst wird kontinuierlich für die fragliche Schutzzone das Vorliegen eines Fehlers unter Verwendung des Zustandsschätzers untersucht. Sollte ein Fehler erkannt worden sein, so kann anschließend durch Berechnung der Ströme und Spannungen an den Grenzen des fehlerbehafteten Abschnitts unter Verwendung der in dem Zustandsschätzer eingesetzten Modellbeschreibung und der bestimmten Zustandsvariablen für gesunde Netzteile außerhalb der betrachteten Schutzzone mittels eines üblichen Fehlerortungsverfahrens auf den konkreten Fehlerort geschlossen werden.

Gemäß einer alternativen vorteilhaften Ausführungsform des erfindungsgemäßen Verfahrens ist vorgesehen, dass bei Vorliegen des Fehlererkennungssignals das Energieversorgungsnetz in mehrere logische Teilabschnitte unterteilt wird, für einzelne Teilabschnitte oder Kombinationen von Teilabschnitten mittels einer Zustandsschätzung überprüft wird, ob sich für den jeweiligen Teilabschnitt oder die Kombination von Teilabschnitten durch die Modellbeschreibung ein elektrischer Zustand des Energieversorgungsnetzes beschreiben lässt, der hinsichtlich der für die jeweiligen Messstellen verwendeten Zustandsvariablen zumindest näherungsweise mit den jeweiligen Zustandswerten übereinstimmt, und von der Auswerteeinrichtung bei Fehlen eines solchen Zustands hinsichtlich eines bestimmten Teilabschnitts oder einer Kombination von Teilabschnitten ein Fehlerzonensignal erzeugt wird, das denjenigen Teilabschnitt des Energieversorgungsnetzes angibt, wo der Fehler erkannt worden ist.

Bei dieser Ausführungsform kann für ein komplexes Energieversorgungsnetz ohne separat überwachte Schutzzonen neben der bloßen Bestimmung, ob ein Fehler in dem Energieversorgungsnetz vorliegt, auch eine Identifizierung des von dem Fehler betroffenen Netzteils durchgeführt werden. Hierzu wird der Zustandsschätzer-Algorithmus auf Teile des Energieversorgungsnetzes angewendet, so dass aus einem Vergleich der Ergebnisse dieser Überprüfung abgeleitet werden kann, welcher Teilabschnitt des Energieversorgungsnetzes von dem Fehler betroffen ist.

Die betrachteten Teilabschnitte müssen hierbei in sich abgeschlossen sein und eine Redundanz der bezüglich ihrer Messstellen erfassten Zustandswerte aufweisen. Dabei kann der Zustandsschätzer-Algorithmus auch auf Kombinationen von Teilabschnitten angewendet werden, solange sichergestellt ist, dass durch einen Vergleich mehrerer betrachteter Teilabschnitte und/oder Kombinationen von Teilabschnitten ein einzelner fehlerbehafteter Teilabschnitt sicher identifiziert werden kann.

Wenn ein Teilabschnitt als von dem Fehler betroffen erkannt worden ist, wird ein entsprechendes Fehlerzonensignal erzeugt, das den fraglichen Abschnitt angibt. Das Fehlerzonensignal kann bei Verwendung des erfindungsgemäßen Verfahrens zum Primär- oder Backupschutz des Energieversorgungsnetzes zur Auslösung entsprechender Schalteinrichtungen (z.B. Leistungsschalter) eingesetzt werden.

Gemäß einer weiteren vorteilhaften Ausführungsform kann zudem vorgesehen sein, dass bei Vorliegen des Fehlerzonensignals für den von dem Fehler betroffenen Teilabschnitt des Energieversorgungsnetzes an einem oder mehreren Enden des Teilabschnittes vorliegende Werte für Ströme und Spannungen bestimmt werden und mittels der so bestimmten Werte für Ströme und Spannungen eine Berechnung desjenigen Ortes innerhalb des Teilabschnittes durchgeführt wird, an dem der Fehler aufgetreten ist.

Auf diese Weise kann innerhalb des identifizierten Teilabschnitts des Energieversorgungsnetzes eine genaue Fehlerortung durchgeführt werden. Anhand der Modellbeschreibung des Energieversorgungsnetzes und den bei der Fehlererkennung und Fehlerzonenidentifizierung bestimmten Zustandsvariablen für die fehlerfreien Teilabschnitte des Energieversorgungsnetzes kann für die Grenzen bzw. Enden des von dem Fehler betroffenen Teilabschnitts eine Angabe über dort vorliegende Ströme und Spannungen gemacht werden. Aus diesen Werten lässt sich anhand an sich bekannter Fehlerortungsalgorithmen der genaue Fehlerort ableiten; dabei können für die Fehlerortung Ströme und Spannungen von einem Ende oder mehreren Enden des Teilabschnitts verwendet werden. Beispiele für Fehlerortungsverfahren finden sich beispielsweise in der US 5,929,642 oder in dem Aufsatz von M.M. Saha, J. Izykowski und E. Rosolowski "Fault Location on Power Networks", 2010, London, Springer-Verlag.

Mittels einer solchen genauen Fehlerortung kann vorteilhaft ein Reparatur- und Wartungsmanagement unterstützt werden.

Prinzipiell wird bei dieser Ausführungsform bis zur Fehlerortung also ein mehrstufiges Verfahren durchlaufen: Zunächst wird kontinuierlich das generelle Vorliegen eines Fehlers hinsichtlich des gesamten Energieversorgungsnetzes unter Verwendung des Zustandsschätzers untersucht. Sollte ein Fehler erkannt worden sein, so wird anschließend durch Verwendung des Zustandsschätzers auf einzelne Teilabschnitte oder Kombinationen von Teilabschnitten eine Identifizierung des von dem Fehler betroffenen Teilabschnitts durchgeführt. Durch Berechnung der Ströme und Spannungen an den Grenzen des fehlerbehafteten Abschnitts unter Verwendung der in dem Zustandsschätzer eingesetzten Modellbeschreibung und der zuvor bestimmten Zustandsvariablen für die gesunden Netzteile kann anschließend mittels eines üblichen Fehlerortungsverfahrens auf den konkreten Fehlerort geschlossen werden.

Konkret kann in diesem Zusammenhang vorgesehen sein, dass als Kostenfunktion die Matrix-Gleichung

$$ J = \left[ z - h(x) \right]^T R^{-1} \left[ z - h(x) \right] $$

verwendet wird, mit

J : Kostenfunktion
z : Vektor der für die Messstellen ermittelten Zustandswerte;
x : Vektor der Zustandsvariablen;
h(x) : Vektor der Zustandsgleichungen zur Modellbeschreibung des Energieversorgungsnetzes;
R : Kovarianz-Matrix des Vektors z );
T : steht für die Transposition der betroffenen Matrix;

Diese Gleichung wird für ein dreiphasiges System minimiert und ergibt einen Satz bzw. Vektor von Zustandsvariablen x, mit dem die Zustandswerte in der Modellbeschreibung mit hinreichender Genauigkeit abgebildet werden können. Mit anderen Worten: die Kostenfunktion wird über die Variablen x minimiert. Hierzu wird das Ergebnis J der Kostenfunktion mit einem Schwellenwert verglichen; solange der Schwellenwert unterschritten wird, kann ein fehlerfreier Zustand angenommen werden.

Um die Zuverlässigkeit der Aussage des Zustandsschätzer noch weiter zu erhöhen, kann in diesem Zusammenhang gemäß einer weiteren Fortbildung des erfindungsgemäßen Verfahrens vorgesehen sein, dass von der Auswerteeinrichtung außerdem für einen jeweiligen als Ergebnis aus der Minimierung der Kostenfunktion hervorgehenden Vektor $\hat{x}$ der Zustandsvariablen ein Prüfwert LNR ermittelt wird gemäß

$$ LNR = \max_i \frac{\left| z_i - h_i(\hat{x}) \right|}{std\left( z_i - h(\hat{x}) \right)} $$

wobei der Index i für den jeweils durch die i-te Komponente der Messfunktion h(x), also dem Vektor der Zustandsgleichungen der Modellbeschreibung des Energieversorgungssystems, beschriebenen Zustand der Modellbeschreibung steht, und dann auf ein Fehlen eines beschreibbaren Zustands geschlossen wird, wenn der Prüfwert einen einstellbaren PrüfSchwellenwert übersteigt. Dabei können die Überprüfungen gemäß der Kostenfunktion J und dem Prüfwert LNR (Largest Normalized Residual) logisch mit UND oder ODER verknüpft sein, d.h. es kann je nach Einstellung des Schutzsystems ein Fehler dann erkannt werden, wenn eine der beiden Überprüfungen oder beide einen Fehler erkennen.

Die Zustandswerte werden üblicherweise mittels an jeweiligen Messstellen in dem Energieversorgungsnetz angeordneten Messsensoren erfasst. Solche gemessenen Zustandswerte werden als verlässlichste Zustandswerte angesehen und können in dem Zustandsschätzerverfahren entsprechend stärker gewichtet werden.

Außerdem kann auch vorgesehen sein, dass zumindest einige der Zustandswerte für bestimmte Messstellen berechnet oder geschätzt werden.

Hierbei werden auf Grundlage der gemessenen Zustandswerte unter Verwendung von Modellen (z.B. Lastmodellen) und oder Netzparametern (z.B. Leitungsimpedanzen) Zustandswerte für diejenigen Messstellen in dem Energieversorgungsnetz ermittelt, an denen, z. B. wegen nicht vorhandener oder defekter Sensoren, keine gemessenen Zustandsvariablen vorliegen. Solche berechneten Zustandswerte werden als weniger zuverlässig als die gemessenen Zustandswerte angesehen und können daher mit geringerer Wichtung in die Zustandsschätzung eingehen.

Außerdem muss der Satz von Messwerten die Ermittlung der Zustandsvariablen ermöglichen. Wenn beispielsweise keine Spannungsmessung erfolgt, ist es nicht möglich den Zustand des Systems zu ermitteln. Wenn das Netz nicht beobachtbar ("observable") ist, kann das Verfahren nicht für die fragliche Schutzzone verwendet werden; oder es müssen mehr Modelle verfügbar sein.

Hinsichtlich der Leitstelleneinrichtung wird die oben genannte Aufgabe durch eine Leitstelleneinrichtung der eingangs genannten Art gelöst, die zur Durchführung eines Verfahrens gemäß einem der Ansprüche 1 bis 9 eingerichtet ist.

Zusammengefasst lässt sich festhalten, dass das erfindungsgemäße Verfahren bzw. die erfindungsgemäße Auswerteeinrichtung eine neuartige Möglichkeit zur Fehlererkennung in Energieversorgungsnetzen angibt, indem mittels eines Zustandsschätzers überprüft wird, ob Modellbeschreibung und Zustandswerte zueinander passen. Da dies nur in einem fehlerfreien Zustand des Energieversorgungsnetzes der Fall ist, kann auf diese Weise zuverlässig erkannt werden, ob ein Fehler in dem Energieversorgungsnetz vorliegt oder nicht. Wenn die Zustandsschätzung direkt für eine abgeschlossene Schutzzone durchgeführt wird, lässt sich der von dem Fehler betroffene Netzteil unmittelbar bestimmen. Andernfalls lässt sich durch Anwendung des Zustandsschätzers auf einzelne Teilabschnitte des Energieversorgungsnetzes der konkrete fehlerbehaftete Teilabschnitt in entsprechender Weise feststellen. Anhand der sich aus der Modellbeschreibung für die fehlerfreien Teilabschnitte ergebenden Werte für Ströme und Spannungen an den Grenzen zum fehlerbehafteten Abschnitt kann schließlich noch eine genaue Fehlerortung stattfinden.

Die Erfindung wird nachfolgenden anhand eines Ausführungsbeispiels näher erläutert. Dabei zeigen

Figur 1    eine schematische Ansicht eines mittels einer Leitstelleneinrichtung überwachten Energieversorgungsnetzes;

Figur 2    eine schematische Darstellung eines Verfahrensablaufs zur Erkennung und Ortung eines Fehlers in einem Energieversorgungsnetz; und

Figur 3    ein Ausführungsbeispiel eines Energieversorgungsnetzes zur Erläuterung des in Figur 2 gezeigten Verfahrensablaufs.

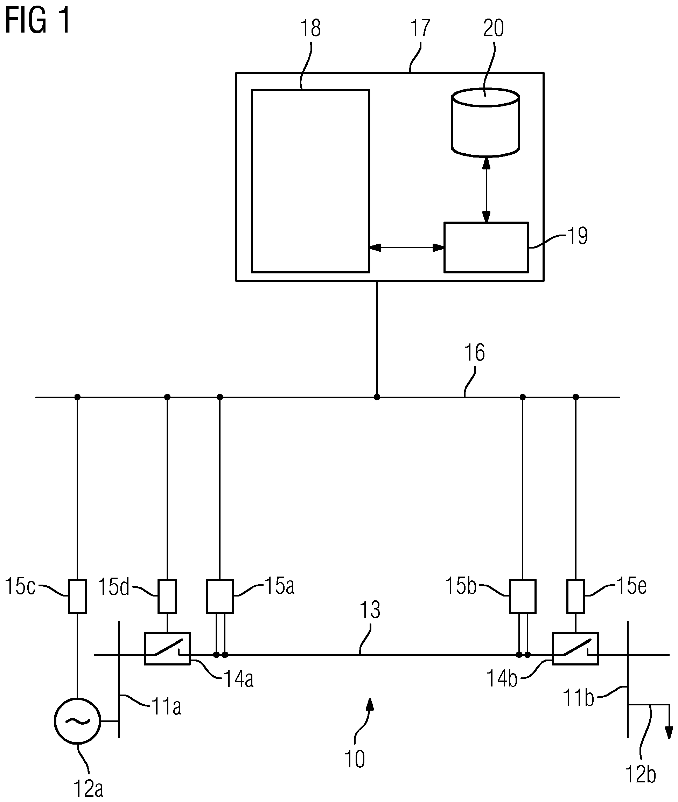

Figur 1 zeigt in schematischer Darstellung ein lediglich beispielhaft angedeutetes elektrisches Energieversorgungsnetz 10, das an einer ersten Sammelschiene 11a eine Quelle 12a und an einer zweiten Sammelschiene 11b eine Last 12b aufweist. Die beiden Sammelschienen 11a und 11b sind über eine Energieversorgungsleitung 13 miteinander verbunden. Die Energieversorgungsleitung 13 kann über Schalteinrichtungen 14a und 14b von den Sammelschienen 11a und 11b abgetrennt werden. Im Bereich der Schalteinrichtungen 14a und 14b sind darüber hinaus Mess- oder Schutzgeräte in Form von IEDs (Intelligent Electronic Devices) 15a und 15b vorgesehen, die Zustandswerte in Form von Stromzeigern und/oder Spannungszeigern an ihren Messstellen des Energieversorgungsnetzes 10 aufnehmen. Darüber hinaus sind weitere IEDs 15c, 15d und 15e vorgesehen; das IED 15c misst einen Zustandswert in Form eines die Einspeisung durch die Quelle 12a angebenden Stromzeigers, während die IEDs 15d und 15e mit den Schalteinrichtungen 14a und 14b verbunden sind und dort Zustandswerte in Form von Schalterstellungen (geöffnet/geschlossen) erfassen. Anstelle der Messung von Strom- und/oder Spannungszeigern können auch einfache Amplitudenmessungen verarbeitet werden.

Alle auf diese Weise erfassten Zustandswerte werden über Kommunikationsverbindungen an einen Kommunikationsbus 16 übermittelt, der wiederum mit einer Leitstelleneinrichtung 17, z.B. einem SCADA-System (Supervisory Control and Data Acquisition), in Verbindung steht und die Zustandswerte an diese überträgt.

Die Leitstelleneinrichtung 17 umfasst eine Auswerteeinrichtung 18, bei der es sich beispielsweise um eine mit spezieller Leitstellensoftware ausgestattete mikroprozessorgesteuerte Datenverarbeitungseinrichtung handeln kann. Die Auswerteeinrichtung 18 steht mit einem Zustandsschätzer-Modul ("State Estimator") 19 in Verbindung, das wiederum Zugriff auf eine Datenbank 20 besitzt, in der Informationen über das Energieversorgungsnetz 10, z.B. Topologiedaten über den Aufbau des Energieversorgungsnetzes 10, technische Kennwerte wie Leitungsadmittanzen, Parameter für Lastmodelle und Schaltzustände der Schalteinrichtungen (z.B. der Schalteinrichtungen 14a, 14b) des Energieversorgungsnetzes 10, abgespeichert sind. Diese Informationen können dynamisch an aktuelle Betriebszustände des Energieversorgungsnetzes angepasst werden, z.B. indem abgespeicherte Schaltzustände den tatsächlichen Schalterstellungen nachgeführt werden. Die in der Datenbank 20 abgespeicherten Informationen dienen dem Zustandsschätzer-Modul 19 zur Erzeugung und zum Betrieb einer Modellbeschreibung, mit der das Energieversorgungsnetz 10 mit mathematisch abgebildet wird.

Zur Erkennung eines Fehlers, z.B. eines Kurzschlusses oder eines Erdschlusses, in dem Energieversorgungsnetz 10 ist die Auswerteeinrichtung 18 dazu eingerichtet, die an den Messstellen in dem Energieversorgungsnetz durch Messung erfassten Zustandswerte und ggf. berechnete Zustandswerte, die z.B. aus den gemessenen Zustandswerten oder unter Verwendung von Lastmodellen für die elektrische Last 12b bestimmt worden sind, mit von dem Zustandsschätzer-Modul ermittelten, für einen fehlerfreien Betrieb des Energieversorgungsnetzes 10 möglichen Zustandsvariablen zu vergleichen. Zustandsvariablen sind in diesem Zusammenhang üblicherweise Spannungszeiger, die mit der Modellbeschreibung für die jeweiligen Messstellen des Energieversorgungsnetzes ermittelt werden. Diese lassen sich, ggf. nach Umrechnung unter Verwendung von Zustandsgleichungen, mit den Zustandswerten, die für die einzelnen Messstellen (durch Messung oder rechnerisch) ermittelt worden sind, vergleichen. Sofern mit dem Zustandsschätzer-Modul ein Betriebszustand des Energieversorgungsnetzes mit solchen Zustandsvariablen abgebildet werden kann, die weitgehend mit den ermittelten Zustandswerten übereinstimmen, wird das Energieversorgungsnetz als fehlerfrei betrachtet, andernfalls kann auf das Vorliegen eines Fehlers geschlossen werden. Mit anderen Worten wird bei dem Verfahren geprüft, ob die mathematische Beschreibung des Energieversorgungsnetzes 10 und der durch die Zustandswerte beschriebene tatsächliche Zustand des Energieversorgungsnetzes 10 in Übereinstimmung sind. Da die Modellbeschreibung ausschließlich zur Beschreibung fehlerfreier Zustände des Energieversorgungsnetzes 10 geeignet ist, kann aus einer fehlenden oder unzureichenden Übereinstimmung auf einen fehlerbehafteten Zustand des Energieversorgungsnetzes 10 geschlossen werden.

Sofern die Zustandsschätzung für eine (oder mehrere) abgeschlossene Schutzzone(n) durchgeführt wird, ist mit Erkennung des Vorliegens eines Fehlers automatisch auch eine Aussage darüber getroffen, in welchem Teil des Energieversorgungsnetzes 10 der Fehler vorliegt. Das Fehlererkennungssignal wird daher bei dieser Ausführungsform in Form eines Fehlerzonensignals erzeugt, das die betroffene Schutzzone angibt.

Wenn hingegen die Fehlererkennung anhand der Zustandsschätzung für das gesamte Energieversorgungsnetz 10 durchgeführt wird, ist auch dann, wenn die Auswerteeinrichtung 18 das Vorliegen eines Fehlers in dem Energieversorgungsnetz 10 erkannt hat, noch keine Aussage über die Lage des Fehlers in dem Energieversorgungsnetz 10, d.h. den fehlerbehafteten Teilabschnitt des Energieversorgungsnetzes 10 möglich. Diese Angabe wird jedoch zur Bestimmung derjenigen Schalteinrichtungen benötigt, die zur Abschaltung des Fehlers ausgelöst werden müssen. Daher wird im Anschluss an die Fehlererkennung üblicherweise eine Fehlerzonenerkennung durchgeführt, während der der von dem Fehler konkret betroffene Teilabschnitt des Energieversorgungsnetzes 10 identifiziert wird. Hierzu wird das Energieversorgungsnetz 10 in mehrere logische Teilabschnitte unterteilt, die separat auf das Vorliegen des Fehlers geprüft werden. Hierbei wird quasi dieselbe Vorgehensweise durchgeführt wie bei der Fehlererkennung: Es wird - diesmal für den fraglichen Teilabschnitt - anhand der für diesen vorliegenden Zustandswerte überprüft, ob ein durch denjenigen Teil der Modellbeschreibung, der für den fraglichen Teilabschnitt gültig ist, beschreibbarer Zustand gefunden werden kann, dessen Zustandsvariablen mit den Zustandswerten in ausreichender Weise übereinstimmen. Wenn ein solcher Satz bzw. Vektor von Zustandsvariablen gefunden werden kann, wird der betrachtete Teilanschnitt als fehlerfrei angesehen. Da häufig nicht für jeden Teilabschnitt in ausreichender Anzahl Messstellen verfügbar sind, für die Zustandswerte ermittelt werden können, kann dieses Verfahren auch für Kombinationen von Teilabschnitten durchgeführt werden. Dies soll an einem einfachen Beispiel erläutert werden: Ein angenommenes Energieversorgungsnetz bestehe aus drei Teilabschnitten A, B und C, wobei in dem Teilabschnitt B keine Messstellen existieren, für den Zustandswerte (durch Messung oder rechnerisch ermittelt werden können). Wird nun durch das beschriebene Verfahren innerhalb der Kombination aus den Teilabschnitten A und B ein Fehler erkannt und wird für den Teilabschnitt A hingegen ein fehlerfreier Zustand festgestellt, so kann durch logische Verknüpfung dieser beiden Ergebnisse darauf geschlossen werden, dass der Fehler innerhalb des Teilabschnitts B liegen muss, so dass dieser abgeschaltet werden kann.

Wird für einen Teilabschnitt des Energieversorgungsnetzes 10 ein Fehler erkannt, so wird von der Auswerteeinrichtung 18 ein Fehlerzonensignal erzeugt, das den von dem Fehler betroffenen Teilabschnitt kennzeichnet.

Zur Fehlerbehebung, für die - falls es sich nicht um einen selbstverlöschenden Fehler handelt - üblicherweise ein Reparaturteam nötig sein wird, muss der genaue Fehlerort innerhalb des betroffenen Teilabschnitts angegeben werden. Hierzu werden diejenigen Strom- und Spannungswerte verwendet, die durch die Modellbeschreibung an den Grenzen bzw. Enden der fehlerbehafteten Schutzzone bzw. des fehlerbehafteten Teilabschnitts ermittelt werden. Hierfür werden für die an die fehlerbehaftete Schutzzone bzw. den fehlerbehafteten Teilabschnitt angrenzenden fehlerfreien Schutzzonen bzw. Teilabschnitte Ströme und Spannungen im Grenzgebiet zur fehlerbehafteten Schutzzone bzw. zum fehlerbehafteten Teilabschnitt berechnet. Dies kann auch dann erfolgen, wenn an den fraglichen Grenzen keine Messstellen vorhanden sind, da durch die Modellbeschreibung ein zu den erfassten Zustandswerten passender Betriebszustand des Energieversorgungsnetzes vollständig - und damit auch an den benötigten Grenzen - beschrieben werden kann. Sobald die benötigten Ströme und Spannungen bestimmt worden sind, kann ein herkömmliches Fehlerortungsverfahren zur Ermittlung des konkreten Fehlerortes eingesetzt werden. Hierbei kann auf ein einseitiges Fehlerortungsverfahren zurückgegriffen werden, wenn nur für ein Ende der fehlerbehafteten Schutzzone bzw. des fehlerbehafteten Teilabschnittes Ströme und Spannungen bestimmt werden können (z.B. wenn die fragliche Schutzzone bzw. der fragliche Teilabschnitt nur auf einer Seite an eine weitere Schutzzone bzw. einen weiteren Teilabschnitt grenzt); liegen hingegen für beide Enden des Ströme und Spannungen vor, so kann auch ein zweiseitiges Fehlerortungsverfahren eingesetzt werden.

Auf diese Weise kann der genaue Fehlerort angegeben werden, so dass das Reparaturteam bei der Fehlersuche und -behebung unterstützt werden kann.

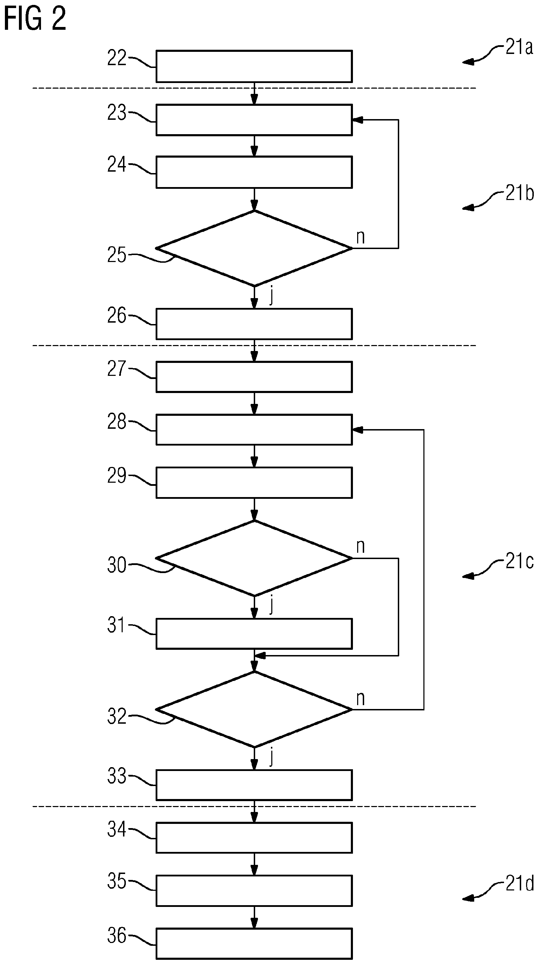

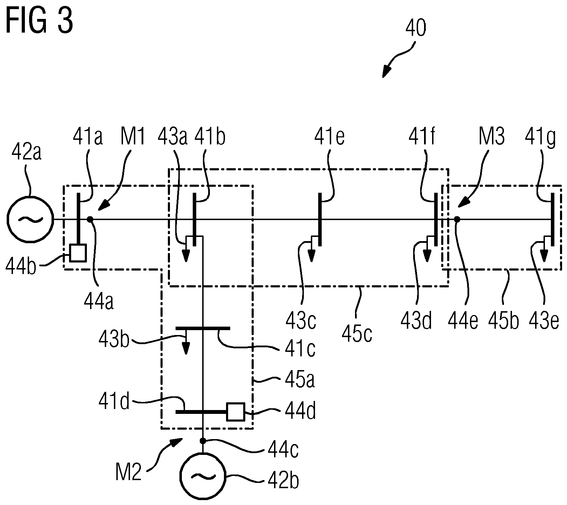

Ein Ausführungsbeispiel eines Verfahrens zur Fehlererkennung mittels einer Zustandsschätzung für das gesamte Energieversorgungsnetz soll nachfolgend anhand der Figuren 2 und 3 näher erläutert werden. Dabei wird auch auf die Fehlerzonenidentifizierung und die Fehlerortung eingegangen. Hierbei zeigt Figur 3 ein vergleichsweise einfach aufgebautes Energieversorgungsnetz 40 mit mehreren Netzknoten 41a - 41g, zwei einspeisenden Quellen 42a, 42b sowie Lasten 43a - 43e. Figur 2 zeigt ein Fließbild des Verfahrensablaufes zur Fehlererkennung, Fehlerzonenidentifizierung und Fehlerortung.

Hierbei ist der Verfahrensablauf in vier Hauptphasen eingeteilt: eine Initialisierungsphase 21a, eine Fehlererkennungsphase 21b, eine Fehlerzonenidentifizierungsphase 21c und eine Fehlerortungsphase 21d. Die einzelnen Phasen sind im Fließbild durch gestrichelte Linien voneinander optisch getrennt.

In der Initialisierungsphase 21a wird in einem Modellbildungs-Schritt 22 die Modellbeschreibung für das Energieversorgungsnetz 40, auf der die Zustandsschätzung basiert, erzeugt. Hierzu wird z.B. anhand von Topologiedaten und elektrischen Kennwerten für das Energieversorgungsnetz 40 eine Admittanzmatrix für die Leitungen des Energieversorgungsnetzes 40 ermittelt. Außerdem werden Lastmodelle für alle oder ausgewählte Lasten 43a - 43e des Energieversorgungsnetzes 40 definiert und - sofern erforderlich - andere Primärkomponenten, wie z.B. Transformatoren, modelliert. Die erzeugte Modellbeschreibung umfasst einen Satz Zustandsgleichungen, mit denen aus Zustandsvariablen mit den Zustandswerten vergleichbare Werte bestimmt werden können. Die Initialisierungsphase 21a wird üblicherweise vor Inbetriebnahme der Auswerteeinrichtung 18 (vgl. Figur 1) sowie bei Bedarf - z.B. aufgrund von Topologieänderungen nach Schaltvorgängen oder baulichen Netzveränderungen - durchgeführt.

Während der anschließenden Fehlererkennungsphase 21b wird das Energieversorgungsnetz 40 auf das Vorliegen von Fehlern, z.B. Kurzschlüssen oder Erdschlüssen, überwacht. Dazu werden in einem Schritt 23 für vorhandene Messstellen in dem Energieversorgungsnetz 40 Zustandswerte erfasst. In dem Ausführungsbeispiel gemäß Figur 3 existieren drei Messstellen: an Messstelle M1 werden mittels einer Strommesseinrichtung 44a Stromzeigermesswerte, die den von Netzknoten 41a zu Netzknoten 41b fließenden Strom angeben, und mittels einer Spannungsmesseinrichtung 44b Spannungszeigermesswerte, die die an Netzknoten 41a anliegende Spannung angeben, erfasst. An Messstelle M2 werden in entsprechender Weise mittels einer Strommesseinrichtung 44c Stromzeigermesswerte, die den an Netzknoten 41d durch Quelle 42b eingespeisten Strom angeben, und mittels einer Spannungsmesseinrichtung 44d Spannungszeigermesswerte, die die an Netzknoten 41d anliegende Spannung angeben, erfasst. Außerdem werden an Messstelle M3 mittels einer Strommesseinrichtung 44e Stromzeigermesswerte, die den von Netzknoten 41f zu Netzknoten 41g fließenden Strom angeben, erfasst. Bei den Messeinrichtungen 44a - 44e kann es sich vorzugsweise um Zeigermesseinrichtungen, sogenannte PMUs ("Phasor Measurement Unit") handeln, die zeitgestempelte Strom- bzw. Spannungszeiger aufnehmen.

Sollten einige Zustandswerte nicht als Strombzw. Spannungszeiger vorliegen oder für einige Messstellen nicht vorhanden sein, können Zustandswerte, zumindest teilweise, auch aus anderen vorhandenen Messwerten abgeleitet oder unter Zuhilfenahme von weiteren Modellen (z.B. Lastmodellen für die Lasten 43a - 43e) berechnet werden. Da die gemessenen Zustandswerte üblicherweise zuverlässiger den tatsächlichen Betriebszustand des Energieversorgungsnetzes 40 abbilden, können sie im Verhältnis zu den rechnerisch ermittelten Zustandswerten für die Zustandsschätzung entsprechend höher gewichtet werden.

Die für die Messstellen M1 - M3 ermittelten Zustandswerte werden in einem folgenden Schritt 24 der Auswerteeinrichtung zugeführt. Diese prüft mittels des Zustandsschätzers, ob ein mit der Modellbeschreibung angebbarer Vektor von Zustandsvariablen existiert, der in ausreichender Weise mit den ermittelten Zustandswerten übereinstimmt. Die Zustandsschätzung selbst kann hier beispielsweise mit einem gewichteten Least-Squares-Schätzverfahren anhand der entsprechend gewichteten Zustandswerte erfolgen. Durch die Zustandsschätzung wird ein Satz von Zustandsvariablen erzeugt. Dabei werden die dreiphasigen Spannungszeiger für die Netzknoten 41a - 41g auf Basis der vorliegenden Zustandswerte geschätzt. Danach führt die Auswerteeinrichtung eine Minimierung einer Kostenfunktion der Zustandsschätzung durch, bei der die Zustandswerte als Zielgrößen verwendet werden. Die Kostenfunktion kann beispielsweise folgende Form annehmen:

$$ J = \left[ z - h(x) \right]^T R^{-1} \left[ z - h(x) \right] $$

mit

J :        Kostenfunktion
z :        Vektor der für die Messstellen ermittelten Zustandswerte;
x :        Vektor der Zustandsvariablen;
h(x) :     Vektor der Zustandsgleichungen zur Modellbeschreibung des Energieversorgungsnetzes;
R :        Kovarianz-Matrix des Vektors z ;
T :        bezeichnet die Transponierte.

Die Minimierung der Kostenfunktion kann hierbei z.B. mittels eines iterativen Newton-Raphson-Verfahrens erfolgen. In Schritt 25 wird geprüft, ob das ermittelte Minimum der Kostenfunktion einen vorgegebenen Schwellenwert überschreitet. Ist dies nicht der Fall, so wird das Verfahren bei Schritt 23 mit der Erfassung weiterer Zustandswerte fortgesetzt. Übersteigt hingegen das Minimum der Kostenfunktion den Schwellenwert, d. h. es existiert kein Vektor von Zustandsvariablen, mit dem der Betriebszustand des Energieversorgungsnetzes 40 hinreichend genau beschrieben werden kann, erkennt die Auswerteeinrichtung einen Fehler in dem Energieversorgungsnetz 40 und gibt in einem folgenden Schritt 26 ein Fehlererkennungssignal ab.

Um die Zuverlässigkeit der Fehlererkennung weiter zu erhöhen, kann in Schritten 24 und 25 zusätzlich zu dem Minimum der Kostenfunktion für die in der Minimierung der Kostenfunktion J ermittelten Vektoren der Zustandsvariablen ein weiterer Prüfwert LNR ermittelt werden:

$$LNR = \max_i \frac{|z_i - h_i(\hat{x})|}{std(z_i - h(\hat{x}))},$$

wobei der Index i für den durch die i-te Komponente der Messfunktion h(x), also dem Vektor der Zustandsgleichungen der Modellbeschreibung des Energieversorgungssystems, beschriebenen Zustand der Modellbeschreibung steht und "std" die Standardabweichung bedeutet, die üblicherweise als Nebenprodukt der Zustandsschätzung ermittelt wird. Das Fehlererkennungssignal kann durch UND- oder ODER-Verknüpfung der Ergebnisse der Minimierung der Kostenfunktion J und der Berechnung des Prüfwertes LNR erzeugt werden. Bei einer ODER-Verknüpfung wird das Fehlererkennungssignal in Schritt 26 auch dann erzeugt, wenn nur die Kostenfunktion ihren Schwellenwert überschreitet oder der Prüfwert LNR einen einstellbaren PrüfSchwellenwert übersteigt; bei einer UND-Verknüpfung müssen zur Erzeugung des Fehlererkennungssignals beide Bedingungen vorliegen.

Mit der Abgabe des Fehlererkennungssignals in Schritt 26 ist die Fehlererkennungsphase 21b beendet.

Bei vorliegendem Fehlererkennungssignal wird die Fehlerzonenidentifizierungsphase 21c gestartet. In einem ersten Schritt 27 dieser Phase wird das Energieversorgungsnetz 40 logisch in geeignete Teilabschnitte unterteilt. Die Teilabschnitte sollten derart festgelegt werden, dass eine Redundanz von Zustandswerten, vorzugsweise hinsichtlich Strommesswerten, an den Grenzen des jeweiligen Teilabschnitts existiert.

Beispielhaft werden für das Energieversorgungsnetz 40 die folgenden drei Teilabschnitte festgelegt: eine erster Teilabschnitt 45a umfasst Netzknoten 41a, 41b, 41c und 41d, da eine Redundanz der Spannungserfassung für den Netzknoten 41b existiert, der die Hauptleitung mit der Abzweigleitung verbindet. Ein zweiter Teilabschnitt 45b umfasst die Leitung zwischen Netzknoten 41f und 41g sowie den Netzknoten 41g, da für diesen Teilabschnitt 45b eine Redundanz durch die Messung des in den Teilabschnitt 45b hinein fließenden Stromes durch die Messeinrichtung 44e existiert. Ein dritter Teilabschnitt 45c schließlich umfasst die Netzknoten 41b, 41e und 41f.

Für diese drei Teilabschnitte 45a - 45c bzw. Kombinationen von diesen Teilabschnitten wird weitgehend dasselbe Verfahren durchgeführt, wie es bei der Fehlererkennung bereits für das gesamte Energieversorgungsnetz 40 angewandt worden ist, außer dass an einen Teilabschnitt begrenzenden Netzknoten nur Zustandswerte in Form von Spannungen und in den Teilabschnitt hinein fließenden Strömen berücksichtigt werden.

In einem folgenden Schritt 28 wird daher der nächste Teilabschnitt oder eine Kombination von Teilabschnitten zur Untersuchung ausgewählt. Daraufhin wird in einem nächsten Schritt 29 die Zustandsschätzung für den fraglichen Teilabschnitt oder die fragliche Kombination von Teilabschnitten auf Grundlage der für diesen Teilabschnitt bzw. diese Kombination von Teilabschnitten verfügbaren Zustandswerte durchgeführt.

Konkret wird beispielsweise in Schritte 28 der erste Teilabschnitt 45a zur Untersuchung ausgewählt und die Zustandsschätzung in Schritt 29 für den ersten Teilabschnitt 45a unter Verwendung der hierfür vorhandenen Zustandswerte (Strommessung an Messstelle M1, Spannungsmessung an Messstellen M1 und M2) durchgeführt. Außerdem wird eine Minimierung der oben bereits genannten Kostenfunktion J - diesmal jedoch für den zu dem ausgewählten Teilabschnitt bzw. der ausgewählten Kombination von Teilabschnitten gehörende Vektor von Zustandsvariablen - durchgeführt. Zur Erhöhung der Zuverlässigkeit der Aussage kann wiederum auch der Prüfwert LNR gemäß der oben angegebenen Gleichung - diesmal jedoch für den ausgewählten Teilabschnitt bzw. die ausgewählte Kombination von Teilabschnitten - durchgeführt werden.

In Schritt 30 wird daraufhin geprüft, ob das Ergebnis der Kostenfunktion J (oder optional der Prüfwert LNR) einen vorgegebenen Schwellenwert (oder Prüfschwellenwert) übersteigt. Ist dies der Fall, so wird in dem nächsten Schritt 31 das Vorliegen eines Fehlers für den betrachteten Teilabschnitt bzw. die betrachtete Kombination von Teilabschnitten abgespeichert. In einem folgenden Schritt 32 wird überprüft, ob bereits alle verfügbaren Teilabschnitte bzw. Kombinationen von Teilabschnitten betrachtet worden sind. Ist dies nicht der Fall, so wird springt der Verfahrensablauf zurück zu Schritt 28 und es wird der nächste Teilabschnitt bzw. die nächste Kombination von Teilabschnitten ausgewählt.

Wird in Schritt 30 hingegen festgestellt, dass das Ergebnis der Kostenfunktion J (oder optional der Prüfwert LNR) unterhalb des Schwellenwertes (bzw. des Prüfschwellenwertes) liegt, so wird das Verfahren direkt bei Schritt 32 fortgesetzt. Alternativ kann jedoch auch in diesem Fall in Schritt 31 ein Ergebniseintrag festgehalten werden, diesmal jedoch bezüglich des Fehlens eines Fehlers in den betrachteten Teilabschnitt bzw. der betrachteten Kombination von Teilabschnitten.

Konkret werden auf diese Weise nach dem Teilabschnitt 45a beispielsweise eine erste Kombination der Teilabschnitte 45a und 45b und danach eine zweite Kombination aller drei Teilabschnitte 45a, 45b und 45c überprüft.

Ergibt die Abfrage in Schritt 32 schließlich, dass alle in Schritt 27 festgelegten Teilabschnitte bzw. Kombinationen von Teilabschnitten überprüft worden sind, wird das Verfahren bei Schritt 33 fortgesetzt, in dem die Ergebnisse der Überprüfungen logisch derart miteinander verknüpft werden, dass der konkrete fehlerbehaftete Teilabschnitt identifiziert werden kann. Außerdem wird in Schritt 33 ein Fehlerzonensignal erzeugt, das den fehlerbehafteten Teilabschnitt angibt.

Konkret kann die Auswertung der Ergebnisse der Überprüfungen bei dem vorliegenden Ausführungsbeispiel beispielsweise wie folgt durchgeführt werden: wenn für den ersten Teilabschnitt 45a ein Fehler erkannt wird, so wird darauf geschlossen, dass der Fehler in dem ersten Teilabschnitt 45a liegt und ein entsprechendes Fehlerzonensignal abgegeben. Hier kann auf eine Überprüfung der ersten Kombination (Teilabschnitte 45a und 45b) und zweiten Kombination (Teilabschnitte 45a, 45b, 45c) verzichtet werden. Wird lediglich für die erste und die zweite Kombination ein fehlerbehafteter Zustand erkannt, für den ersten Teilabschnitt 45a jedoch ein fehlerfreier Zustand festgestellt, so wird darauf geschlossen, dass der Fehler im dritten Teilabschnitt 45c liegt und ein entsprechendes Fehlerzonensignal abgegeben. Weitere logische Verknüpfungen können entsprechend der jeweiligen Netztopologie leicht erzeugt werden.

Mit Schritt 33 ist die Fehlerzonenidentifizierungsphase 21c beendet und der Verfahrensablauf wird bei vorliegendem Fehlerzonensignal mit Schritt 34 in der Fehlerortungsphase fortgesetzt.

In Schritt 34 werden anhand der in der Fehlerzonenidentifizierungsphase 21c durchgeführten Zustandsschätzungen für die fehlerfreien Teilabschnitte bzw. Kombinationen von Teilabschnitten Ströme und Spannungen an mindestens einem Ende des fehlerhaften Teilabschnitts ermittelt. In Abhängigkeit davon, für wie viele Enden des fehlerhaften Teilabschnittes diese Strom- und Spannungsinformationen vorliegen, wird im folgenden Schritt 35 ein - an sich bekanntes - einseitiges oder zweiseitiges Fehlerortungsverfahren durchgeführt.

Wird beispielsweise konkret angenommen, dass in der Fehlerzonenidentifizierungsphase 21c der dritte Teilabschnitt 45c als fehlerbehaftet erkannt worden ist, so wird anhand der Zustandsschätzung für den gesunden zweiten Teilabschnitt 45b die Spannung am Netzknoten 41f sowie der vom Netzknoten 41f zum Netzknoten 41g fließende Strom bestimmt. Damit liegen für den ein Ende des fehlerbehafteten Teilabschnitts 45c bildenden Netzknoten 41f Strom und Spannung vor, und es kann ein einseitiges Fehlerortungsverfahren durchgeführt werden, um den genauen Ort des Fehlers zu ermitteln.

Dieser Fehlerort wird schließlich in Schritt 36 als Fehlerortsignal ausgegeben. Damit ist der Verfahrensablauf beendet und kann erneut bei der Fehlererkennungsphase 21b begonnen werden.

Wird die Zustandsschätzung anstelle für das gesamte Energieversorgungsnetz bereits auf eine oder mehrere abgeschlossene Schutzzonen angewandt, so bildet das Ergebnis der Fehlererkennungsphase 21b bereits das Ergebnis der Fehlerzonenidentifizierungsphase 21c ab, so dass in diesem Fall nach Abschluss der Fehlererkennungsphase 21b direkt die Fehlerortungsphase 21d folgt.

## Patentansprüche

1. Verfahren zum Erkennen eines Fehlers in einem elektrischen Energieversorgungsnetz (10, 40), bei dem

- für mehrere Messstellen (M1, M2, M3) in dem Energieversorgungsnetz (10, 40) Zustandswerte bestimmt werden, die einen an der jeweiligen Messstelle (M1, M2, M3) vorliegenden elektrischen Zustand des Energieversorgungsnetzes (10, 40) angeben;
- die Zustandswerte zu einer zentralen Leitstelleneinrichtung (17) übermittelt werden, die eine Auswerteeinrichtung (18) umfasst; und
- die Zustandswerte von der Auswerteeinrichtung (18) zur Erkennung eines in dem Energieversorgungsnetz (10, 40) vorliegenden Fehlers herangezogen werden;
- mittels der Auswerteeinrichtung (18) eine Zustandsschätzung ausgeführt wird, die sich einer Modellbeschreibung des elektrischen Energieversorgungsnetzes (10, 40) bedient, die zur Beschreibung möglicher elektrischer Zustände des Energieversorgungsnetzes (10, 40) anhand von Zustandsvariablen geeignet ist;
**dadurch gekennzeichnet, dass**
- während der Zustandsschätzung überprüft wird, ob sich durch die Modellbeschreibung ein elektrischer Zustand des Energieversorgungsnetzes (10, 40) beschreiben lässt, der hinsichtlich der für die jeweiligen Messstellen (M1, M2, M3) verwendeten Zustandsvariablen zumindest näherungsweise mit den jeweiligen Zustandswerten übereinstimmt, indem mittels der Auswerteeinrichtung eine Minimierung einer Kostenfunktion von durch die Modellbeschreibung beschriebenen Zuständen des Energieversorgungsnetzes (10, 40) durchgeführt wird, um denjenigen Satz von Zustandsvariablen aus allen möglichen Zustandsvariablen zu ermitteln, mittels dessen mit der Modellbeschreibung die tatsächlich in dem Energieversorgungsnetz vorliegenden Zustandswerte abgebildet werden können;
- auf ein Fehlen eines beschreibbaren Zustands geschlossen wird, wenn das Ergebnis der Kostenfunktion oberhalb eines einstellbaren Schwellenwertes liegt; und
- bei Fehlen eines solchen Zustands von der Auswerteeinrichtung (18) ein Fehlererkennungssignal erzeugt wird, das ein Vorliegen eines Fehlers in dem Energieversorgungsnetz (10, 40) angibt.

2. Verfahren nach Anspruch 1, **dadurch gekennzeichnet, dass**

- die Zustandsschätzung mittels der Auswerteeinrichtung (18) für eine abgegrenzte Schutzzone des Energieversorgungsnetzes (10, 40) ausgeführt wird;
- während der Zustandsschätzung überprüft wird, ob sich durch die Modellbeschreibung ein elektrischer Zustand der Schutzzone beschreiben lässt, der hinsichtlich der für die in der Schutzzone liegenden jeweiligen Messstellen (M1, M2, M3) verwendeten Zustandsvariablen zumindest näherungsweise mit den jeweiligen Zustandswerten übereinstimmt; und
- bei Fehlen eines solchen Zustands von der Auswerteeinrichtung (18) das Fehlererkennungssignal in Form eines Fehlerzonensignals erzeugt wird, das ein Vorliegen eines Fehlers in der Schutzzone angibt.

3. Verfahren nach Anspruch 2,

- bei Vorliegen des Fehlerzonensignals für die von dem Fehler betroffene Schutzzone an einem oder mehreren Enden der Schutzzone vorliegende Werte für Ströme und Spannungen bestimmt werden und mittels der so bestimmten Werte für Ströme und Spannungen eine Berechnung desjenigen Ortes innerhalb der Schutzzone durchgeführt wird, an dem der Fehler aufgetreten ist.

4. Verfahren nach Anspruch 1, **dadurch gekennzeichnet, dass**

- bei Vorliegen des Fehlererkennungssignals das Energieversorgungsnetz (10, 40) in mehrere logische Teilabschnitte (45a, 45b, 45c) unterteilt wird;
- für einzelne Teilabschnitte (45a, 45b, 45c) oder Kombinationen von Teilabschnitten (45a, 45b, 45c) mittels einer Zustandsschätzung überprüft wird, ob sich für den jeweiligen Teilabschnitt (45a, 45b, 45c) oder die Kombination von Teilabschnitten (45a, 45b, 45c) durch die Modellbeschreibung ein elektrischer Zustand des Energieversorgungsnetzes (10, 40) beschreiben lässt, der hinsichtlich der für die jeweiligen Messstellen (M1, M2, M3) verwendeten Zustandsvariablen zumindest näherungsweise mit den jeweiligen Zustandswerten übereinstimmt; und
- von der Auswerteeinrichtung (18) bei Fehlen eines solchen Zustands hinsichtlich eines bestimmten Teilabschnitts (45a, 45b, 45c) oder einer Kombination von Teilabschnitten (45a, 45b, 45c) ein Fehlerzonensignal erzeugt wird, das denjenigen Teilabschnitt (45a, 45b, 45c) des Energieversorgungsnetzes (10, 40) angibt, für den der Fehler erkannt worden ist.

5. Verfahren nach Anspruch 4,

- bei Vorliegen des Fehlerzonensignals für den von dem Fehler betroffenen Teilabschnitt (45a, 45b, 45c) des Energieversorgungsnetzes (10, 40) an einem oder mehreren Enden des Teilabschnittes (45a, 45b, 45c) vorliegende Werte für Ströme und Spannungen bestimmt werden und mittels der so bestimmten Werte für Ströme und Spannungen eine Berechnung desjenigen Ortes innerhalb des Teilabschnittes (45a, 45b, 45c) durchgeführt wird, an dem der Fehler aufgetreten ist.

6. Verfahren nach einem der vorangehenden Ansprüche, **dadurch gekennzeichnet, dass**

- als Kostenfunktion die Gleichung

$$J = \left[z - h(x)\right]^{T} R^{-1} \left[z - h(x)\right]$$

verwendet wird, mit

J : Kostenfunktion
z : Vektor der für die Messstellen ermittelten Zustandswerte;
x : Vektor der Zustandsvariablen;
h(x) : Vektor der Zustandsgleichungen zur Modellbeschreibung des Energieversorgungsnetzes;
R : Kovarianz-Matrix des Vektors z .

7. Verfahren nach Anspruch 6, **dadurch gekennzeichnet, dass**

- von der Auswerteeinrichtung außerdem für einen jeweiligen als Ergebnis aus der Minimierung der Kostenfunktion hervorgehenden Vektor der Zustandsvariablen ein Prüfwert ermittelt wird gemäß

$$LNR = \max_{i} \frac{\left|z_i - h_i(\hat{x})\right|}{std\left(z_i - h(\hat{x})\right)}$$

wobei der Index i für den durch die i-te Komponente des Vektors der Zustandsgleichungen der Modellbeschreibung des Energieversorgungssystems beschriebenen Zustand der Modellbeschreibung steht; und
- dann auf ein Fehlen eines beschreibbaren Zustands geschlossen wird, wenn der Prüfwert einen einstellbaren PrüfSchwellenwert übersteigt.

8. Verfahren nach einem der vorangehenden Ansprüche,
**dadurch gekennzeichnet, dass**

- zumindest einige der Zustandswerte für bestimmte Messstellen (M1, M2, M3) berechnet oder geschätzt werden.

9. Leitstelleneinrichtung (17) zum Erkennen eines Fehlers in einem elektrischen Energieversorgungsnetz (10, 40), mit einer Auswerteeinrichtung (18) zur Erfassung von für mehrere Messstellen (M1, M2, M3) in dem Energieversorgungsnetz (10, 40) ermittelten Zustandswerten, die einen an der jeweiligen Messstelle (M1, M2, M3) vorliegenden elektrischen Zustand des Energieversorgungsnetzes (10, 40) angeben, wobei die Auswerteeinrichtung (18) zur Erkennung eines in dem Energieversorgungsnetz (10, 40) vorliegenden Fehlers anhand der Zustandswerte eingerichtet ist;
**dadurch gekennzeichnet, dass**

- die Auswerteeinrichtung (18) zur Durchführung eines Verfahrens gemäß einem der Ansprüche 1 bis 8 eingerichtet ist.

**Claims**

1. Method for detecting a fault in an electrical energy supply network (10, 40), wherein

- state values are determined for a plurality of measuring points (M1, M2, M3) in the energy supply network (10, 40), which state values indicate an electrical state of the energy supply network (10, 40) that is present at the respective measuring point (M1, M2, M3);
- the state values are transmitted to a centralised control center device (17) which comprises an evaluation device (18); and
- the state values are used by the evaluation device (18) for the purpose of detecting a fault that is present in the energy supply network (10, 40);
- the evaluation device (18) is used to perform a state estimation which makes use of a model description of the electrical energy supply network (10, 40) that is suitable for describing possible electrical states of the energy supply network (10, 40) on the basis of state variables;
**characterised in that**
- a check is carried out during the state estimation to determine whether the model description allows an electrical state of the energy supply network (10, 40) to be described which, in respect of the state variables used for the respective measuring points (M1, M2, M3), at least approximately agrees with the respective state values, **in that** a minimisation of a cost function of states of the energy supply network (10, 40) which are described by means of the model description is performed by means of the evaluation device in order to determine, from all of the possible state variables, that set of state variables by means of which the state values actually present in the energy supply network can be mapped by the model description;
- an absence of a describable state is inferred if the result of the cost function lies above a selectable threshold value; and
- in the absence of such a state the evaluation device (18) generates a fault detection signal which indicates the presence of a fault in the energy supply network (10, 40).

2. Method according to claim 1,
**characterised in that**

- the state estimation by means of the evaluation device (18) is performed for a delimited protection zone of the energy supply network (10, 40);
- a check is carried out during the state estimation to determine whether the model description allows an electrical state of the protection zone to be described which, in respect of the state variables used for the respective measuring points (M1, M2, M3) lying in the protection zone, at least approximately agrees with the respective state values; and
- in the absence of such a state the evaluation device (18) generates the fault detection signal in the form of a fault zone signal which indicates the presence of a fault in the protection zone.

3. Method according to claim 2,

- if the fault zone signal is present for the protection zone affected by the fault, values for currents and voltages present at one or more ends of the protection zone are determined and by means of the thus determined values for currents and voltages a calculation is performed to identify that location within the protection zone at which the fault occurred.

4. Method according to claim 1,

**characterised in that**

- if the fault detection signal is present, the energy supply network (10, 40) is subdivided into a plurality of logical subsections (45a, 45b, 45c);
- a check is carried out for individual subsections (45a, 45b, 45c) or combinations of subsections (45a, 45b, 45c) by means of a state estimation to determine whether an electrical state of the energy supply network (10, 40) can be described for the respective subsection (45a, 45b, 45c) or the combination of subsections (45a, 45b, 45c) by means of the model description, which state agrees in respect of the state variables used for the respective measuring points (M1, M2, M3) at least approximately with the respective state values; and
- in the absence of such a state in respect of a specific subsection (45a, 45b, 45c) or a combination of subsections (45a, 45b, 45c), the evaluation device (18) generates a fault zone signal which indicates that subsection (45a, 45b, 45c) of the energy supply network (10, 40) for which the fault was detected.

5. Method according to claim 4,

- if the fault zone signal is present for the subsection (45a, 45b, 45c) of the energy supply network (10, 40) affected by the fault, values for currents and voltages present at one or more ends of the subsection (45a, 45b, 45c) are determined and by means of the thus determined values for currents and voltages a calculation is performed to identify that location within the subsection (45a, 45b, 45c) at which the fault occurred.

6. Method according to one of the preceding claims, **characterised in that**

- the equation

$$J = [z - h(x)]^T R^{-1} [z - h(x)]$$

is used as the cost function, where

J : is the cost function
z : is the vector of the state values determined for the measuring points;
x : is the vector of the state variables
h(x) : is the vector of state equations for the model description of the energy supply network;
R : is the covariance matrix of the vector z .

7. Method according to claim 6, **characterised in that**

- a test value is determined in addition by the evaluation device for a respective vector of the state variables emerging as the result from the minimisation of the cost function, according to

$$LNR = \max_i \frac{|z_i - h_i(\hat{x})|}{std(z_i - h(\hat{x}))}$$

where the index i stands for the state of the model description described by means of the i-th component of the vector of the state equations of the model description of the energy supply system; and
- an absence of a describable state is inferred when the test value exceeds a selectable test threshold value.

8. Method according to one of the preceding claims, **characterised in that**

- at least some of the state values for specific measuring points (M1, M2, M3) are calculated or estimated.

9. Control centre device (17) for detecting a fault in an electrical energy supply network (10, 40), comprising an evaluation device (18) for acquiring state values ascertained for a plurality of measuring points (M1, M2, M3) in the energy supply network (10, 40), which state values indicate an electrical state of the energy supply network (10, 40) that is present at the respective measuring point (M1, M2, M3), wherein the evaluation device (18) is configured for detecting a fault that is present in the energy supply network (10, 40) on the basis of the state values; **characterised in that**

- the evaluation device (18) is configured for performing a method according to one of claims 1 to 8.

**Revendications**

1. Procédé de détection d'un défaut d'un réseau (10, 40) d'alimentation en énergie électrique, dans lequel

- on détermine, pour plusieurs points (M1, M2, M3) de mesure du réseau (10, 40) d'alimentation en énergie, des valeurs d'état, qui indiquent un état électrique présent aux points (M1, M2, M3) de mesure respectifs du réseau (10, 40) d'alimentation en énergie ;
- on transmet les valeurs d'état à un dispositif (17) central de direction, qui comprend un dispositif (18) d'exploitation et

- les valeurs d'état sont mises à profit par le dispositif (18) d'exploitation, pour détecter un défaut présent dans le réseau (10, 40) d'alimentation en énergie ;

- on effectue, au moyen du dispositif (18) d'exploitation, une estimation d'état, qui se sert d'une description par modèle du réseau (10, 40) d'alimentation en énergie électrique, propre à décrire des états électriques possibles du réseau (10, 40) d'alimentation en énergie, à l'aide de variables d'état ;

**caractérisé en ce que**

- on contrôle, pendant l'estimation d'état, si l'on peut décrire, par la description par modèle, un état électrique du réseau (10, 40) d'alimentation en énergie, qui, du point de vue des variables d'état utilisées pour les points (M1, M2, M3) de mesure respectifs, coïncide, au moins à peu près, avec les valeurs d'état respectives, en effectuant, au moyen du dispositif d'exploitation, une minimisation d'une fonction de coût d'états du réseau (10, 40) d'alimentation en énergie décrits par la description par modèle, afin de déterminer, parmi toutes les variables d'état possibles, le jeu de variables d'état au moyen duquel on peut reproduire, par la description par modèle, les valeurs d'état présentes réellement dans le réseau d'alimentation en énergie ;

- on décide d'une absence d'un état pouvant être décrit, si le résultat de la fonction de coût est supérieur à une valeur de seuil réglable et

- en l'absence d'un état de ce genre, on produit, par le dispositif (18) d'exploitation, un signal de détection de défaut, qui indique la présence d'un défaut dans le réseau (10, 40) d'alimentation en énergie.

**2.** Procédé suivant la revendication 1,
**caractérisé en ce que**

- on effectue l'estimation d'état au moyen du dispositif (18) d'exploitation, pour une zone de protection délimitée du réseau (10, 40) d'alimentation en énergie ;

- on contrôle, pendant l'estimation d'état, si l'on peut décrire, par la description par modèle, un état électrique de la zone de protection, qui coïncide, du point de vue des variables d'état utilisées pour les points (M1, M2, M3) de mesure respectifs se trouvant dans la zone de protection, au moins à peu près, avec les valeurs d'état respectives et

- en l'absence d'un état de ce genre, on produit, par le dispositif (18) d'exploitation, le signal de détection de défaut, sous la forme d'un signal de zone de défaut, qui indique la présence d'un défaut dans la zone de protection.

**3.** Procédé suivant la revendication 2,

- en présence du signal de zone de défaut pour la zone de protection concernée par le défaut, on détermine des valeurs de courant et de tension présentes à une extrémité ou à plusieurs extrémités de la zone de protection et, au moyen des valeurs ainsi déterminées de courant et de tension, on effectue un calcul de l'emplacement au sein de la zone de protection où le défaut est apparu.

**4.** Procédé suivant la revendication 1,
**caractérisé en ce que**

- en présence du signal de détection de défaut, on subdivise le réseau (10, 40) d'alimentation en énergie en plusieurs sous-segments (45a, 45b, 45c) logiques ;

- on contrôle, pour divers sous-segments (45a, 45b, 45c) ou combinaisons de sous-segments (45a, 45b, 45c), au moyen d'une estimation d'état, si l'on peut décrire, pour le sous-segment (45a, 45b, 45c) respectif ou la combinaison de sous-segments (45a, 45b, 45c) par la description par modèle, un état électrique du réseau (10, 40) d'alimentation en énergie, qui, du point de vue des variables d'état utilisées pour les points (M1, M2, M3) de mesure respectifs, coïncide, au moins à peu près, avec les valeurs d'état respectives et

- il est produit, par le dispositif (18) d'exploitation, en l'absence d'un état de ce genre, en ce qui concerne un sous-segment (45a, 45b, 45c) déterminé ou une combinaison de sous-segments (45a, 45b, 45c), un signal de zone de défaut, qui indique le sous-segment (45a, 45b, 45c) du réseau (10, 40) d'alimentation en énergie, pour lequel le défaut a été détecté.

**5.** Procédé suivant la revendication 4,

- en présence du signal de zone de défaut, on détermine, pour le sous-segment (45a, 45b, 45c) concerné par le défaut du réseau (10, 40) d'alimentation en énergie, des valeurs de courant et de tension présentes à une extrémité ou à plusieurs extrémités du sous-segment (45a, 45b, 45c) et, au moyen des valeurs ainsi déterminées de courant et de tension, on effectue un calcul de l'emplacement au sein du sous-segment (45a, 45b, 45c) où le défaut est apparu.

**6.** Procédé suivant l'une des revendications précédentes, **caractérisé en ce que**

- on utilise comme fonction de coût l'équation

$$J = [z - h(x)]^T R^{-1} [z - h(x)]$$

dans laquelle

    J : est la fonction de coût
    z : est un vecteur des valeurs d'état déterminées pour les points de mesure ;
    x : est un vecteur des variables d'état ;
    h(x) : est un vecteur des équations d'état pour la description par modèle du réseau d'alimentation en énergie ;
    R : est la matrice de covariance du vecteur z.

**7.** Procédé suivant la revendication 6, **caractérisé en ce que**

    - on détermine, par le dispositif d'exploitation, en outre, pour un vecteur des variables d'état provenant du résultat de la minimisation de la fonction de coût, une valeur de contrôle suivant

$$LNR = \max \frac{|zi - hi(\hat{x})|}{std(zi - h(\hat{x}))}$$

    dans laquelle l'indice i représente l'état de la description par modèle décrit par le ième composant du vecteur des équations d'état de la description par modèle du système d'alimentation en énergie et
    - on décide ensuite d'une absence d'un état pouvant être décrit, si la valeur de contrôle dépasse une valeur de seuil de contrôle réglable.

**8.** Procédé suivant l'une des revendications précédentes, **caractérisé en ce que**

    - on calcule ou on estime au moins certaines des valeurs d'état pour certains points (M1, M2, M3) de mesure.

**9.** Dispositif (17) de direction pour détecter un défaut dans un réseau (10, 40) d'alimentation en énergie électrique ayant un dispositif (18) d'exploitation pour relever des valeurs d'état, qui sont déterminées pour plusieurs points (M1, M2, M3) de mesure du réseau (10, 40) d'alimentation en énergie et qui indique un état électrique du réseau (10, 40) d'alimentation en énergie présent aux points (M1, M2, M3) de mesure respectifs, le dispositif (18) étant conçu pour détecter, à l'aide des valeurs d'état, un défaut présent du réseau (10, 40) d'alimentation en énergie ; **caractérisé en ce que**

- le dispositif (18) d'exploitation est conçu pour effectuer un procédé suivant l'une des revendications 1 à 8.

FIG 1

# FIG 2

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6518768 B1
- US 6985784 B2
- US 5929642 A

**In der Beschreibung aufgeführte Nicht-Patentliteratur**

- **A. ABUR ; A. GOMEZ EXPOSITO.** Power System State Estimation. Marcel Dekker, 2004
- **C. LU, J. TENG ; W.-H. E. LIU.** Distribution system state estimation. *IEEE Transactions on Power Systems,* 1995, 229-240
- **MICHAEL HURTGEN.** Advantages of power system state estimation using Phasor Measurement Units. *Proceedings of the Power Systems Computation Conference,* 2008
- **M.M. SAHA ; J. IZYKOWSKI ; E. ROSOLOWSKI.** Fault Location on Power Networks. Springer-Verlag, 2010